# EUROPEAN PATENT APPLICATION

(11) **EP 0 971 237 A2**
(43) Date of publication of application: **12.01.2000**
(21) Application number: 99305378.4
(22) Date of filing: 06.07.1999
(51) Int. Cl.: G01R 13/34

(54) **A simple digital storage oscilloscope user interface**

(30) Priority: 10.07.1998 US 113204
(71) Applicant: TEKTRONIX, INC., Wilsonville, Oregon 97070-1000 (US)
(72) Inventor: Dobyns, Kenneth P., Beaverton, Oregon 97007 (US)
(74) Representative: Burke, Steven David

(57) **Abstract**

A digital storage oscilloscope, which has a plurality of controls, includes a display screen, and menu generation circuitry for displaying a basic menu on the display screen. The basic menu includes a plurality of entries respectively corresponding to a plurality of basic controls. The basic controls are selected from among the plurality of controls, and are those which are more frequently used by a user of the oscilloscope.

## Description

### FIELD OF THE INVENTION

The present invention relates to a user interface for a digital storage oscilloscope.

### BACKGROUND OF THE INVENTION

Early analog oscilloscope user interfaces were front panels containing physical oscilloscope controls. On these front panels were controls for each function. These controls included, e.g. switches or pushbuttons for each control a user could select, and variable controls, such as knobs or dials, for each control for which a user could specify a value. Each one of these controls was labeled. The status of each of the various functions was indicated on the control panel by the position of the switch; a light, such as a light emitting diode (LED); or by an indicator on the knob or dial. A user could easily determine what functions were available on such an oscilloscope, the controls related to those functions, and the status and settings of those controls by visually scanning the front panel. Adjustment of any of the controls was simply a matter of adjusting the labeled control. This was a relatively simple user interface.

As oscilloscopes evolved, the number of functions they could perform increased, and the controls necessary for those functions increased accordingly. In particular, digital storage oscilloscopes (DSOs) included many more functions than the analog oscilloscopes. In order to permit a user to access and control all of these functions, DSOs allocated a portion of the display screen on which the observed waveforms were displayed to display menus. These menus displayed the functions available to the user, the user controls available to control those functions, and the status of those user controls. The control panel of the DSO included an array of physical switches, in the form of push buttons, called menu selection switches. To activate a desired menu, the menu selection switch associated with the desired menu was activated. In response, the desired menu was displayed on the display screen of the DSO. The control panel of the DSO also included an array of physical switches called bezel buttons, adjacent to the display device bezel. Each bezel button was associated with an entry in the menu currently being displayed, and that menu entry corresponded to a control related to that function. Pressing the bezel buttons effected changes in the associated control on the displayed menu.

The effect of manipulating the physical controls, and in particular the bezel buttons, on the control panel of such a DSO depended upon which menu is displayed. In general, each menu was dedicated to one function; or one subset of controls for a function, if that function required more controls than were available in a single menu. Activating the bezel button effected a change in the control displayed in the adjacent menu entry. In order to determine what functions were available, what controls were available for those functions, and what were the status of those controls, the user had to sequence through all the available menus by activating all the menu selection switches. When the user wished to change the setting of a particular control, the menu associated with that control had to be found and activated, then the desired control changed. This presented a relatively complicated user interface which was frustrating to a user.

In some DSOs, one menu was always displayed, and no attempt was made to reclaim the portion of the display screen allocated to the menus when the menus were not being used. Instead, this space remained allocated to the menus. However, other DSOs contained a "clear menus" button, which erased the menus and allowed the portion of the display screen previously allocated to the menus to be used for other purposes, such as additional status information, or larger waveform displays.

A DSO with a simplified user interface is desirable.

### BRIEF SUMMARY OF THE INVENTION

The inventor has realized that there are a group of functions associated with operation of any oscilloscope, access to which is most often required by the user. Each of these functions is associated with a plurality of controls which determines the operation of that function. These functions, and associated basic controls, include, for example, vertical controls, trigger controls, and signal acquisition controls. Other, similar, functions, and associated controls, may also be grouped among the basic group controls. The inventor has designed a DSO, including a control subsystem which displays a basic menu on the display screen, whenever desired by the user. This basic menu contains menu entries for the basic controls, i.e. those to which users most often require access.

In accordance with principles of the present invention, a digital storage oscilloscope, which has a plurality of controls, includes a display screen, and menu generation circuitry for displaying a basic menu on the display screen. The basic menu includes a plurality of entries respectively corresponding to a plurality of basic controls. The basic controls are selected from among the plurality of controls, and are those which are more frequently used by a user of the oscilloscope..

In accordance with another aspect of the invention is a method for controlling a digital storage oscilloscope having a plurality of controls and comprising a display screen. The method comprising the following steps. First, from among the plurality of controls, a plurality of basic controls is specified. The basic controls are those which are more frequently used by a user of the oscilloscope. A basic menu is displayed on the display screen. The basic menu contains a plurality of entries respectively corresponding to the basic controls.

A DSO according to the present invention permits easy access to the basic controls which are most often required by the use, while permitting the user to access the other, more advanced, functions, and associated controls, using other menus, in the known manner.

### BRIEF DESCRIPTION OF THE DRAWING

In the drawing:
Fig. 1 is a diagram illustrating a portion of the display screen and control panel of a digital storage oscilloscope according to the present invention; and
Fig. 2 is a block diagram of a portion of the circuitry of a digital storage oscilloscope according to the present invention.

### DETAILED DESCRIPTION OF THE INVENTION

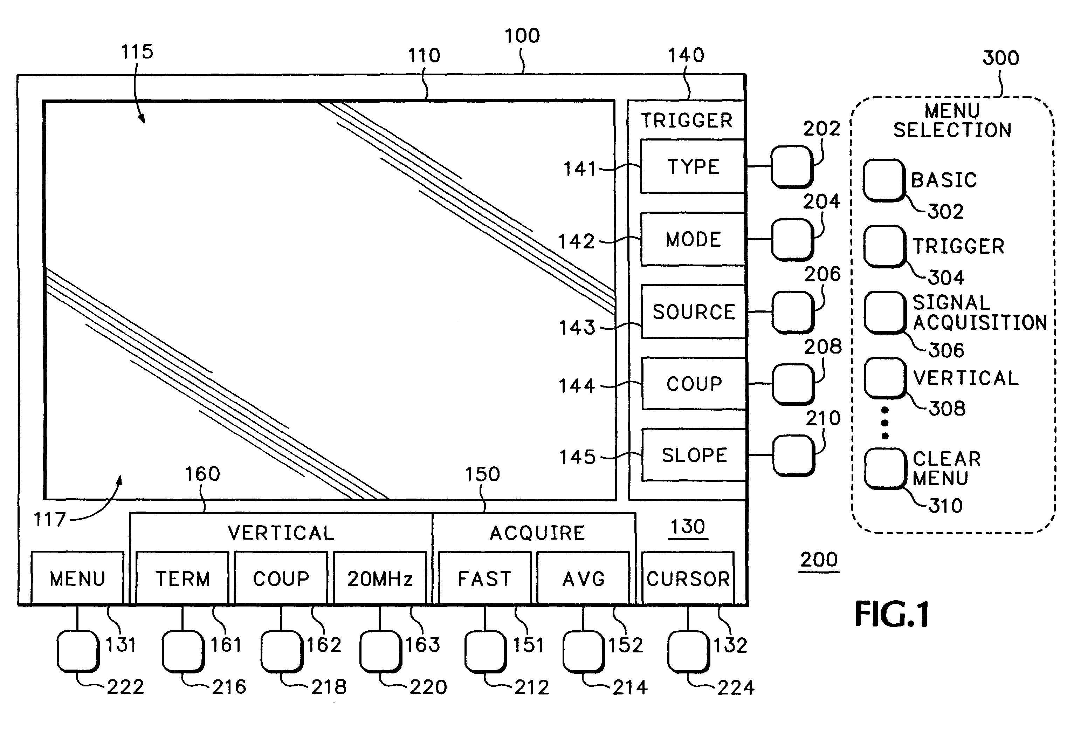

Fig. 1 is a diagram illustrating a portion of the front panel of a digital storage oscilloscope (DSO) containing a display screen and control panel of according to the present invention. This oscilloscope includes a set of functions. These functions include not only the basic functions, such as might be found in an analog oscilloscope, but also the more advanced functions made possible by digital storage oscilloscopes. Each of these functions has a set of controls related to that function. These controls determine how the oscilloscope implements the related function for the particular signal being observed. A subset of these controls are termed basic controls. The basic controls are those which are most often accessed by a user of the oscilloscope. The remaining functions and related controls are termed advanced functions and controls, and are those which are least often accessed by the user. Other controls may be present on the control panel of the DSO which are not germane to understanding the present invention, and are not illustrated for simplicity. One skilled in the art will understand what other controls are necessary, and how they interact with the illustrated controls.

In Fig. 1, the DSO front panel includes a display screen 100, a plurality of bezel buttons 200, represented by rounded squares, and a plurality of menu selections switches 300, also represented by rounded squares. The display screen 100 includes a region 110 allocated to the display of observed waveforms, and a region 130, along the right hand side and the bottom of the display screen 100, allocated to the display of menus. The waveform display region 110 is illustrated as gray because waveforms are displayed as white waveforms on a dark background, in the same manner of analog oscilloscopes. The waveform display region 110, has a graticule (not shown) superimposed on it in a known manner, and includes a first region 115 and a second region 117. The observed waveform is displayed in the combined regions 115 and 117. Additional information relating to the displayed waveform, such as the sensitivity in the vertical and horizontal directions, may be displayed in the second region 117.

The DSO can display a number of different menus in the menu region 130. Each menu which can be displayed in the menu region 130 contains a number of entries. Each menu entry is associated with one DSO control, and includes text which describes the control and the possible states that control can assume. The currently selected state for the control associated with that menu entry is highlighted in some manner, such as being higher intensity or a different color. This in not illustrated in Fig. 1 for simplicity. Each of the menu entries also is associated with one of the bezel buttons 200. This is illustrated in Fig. 1 by a thick line between the bezel button and the corresponding menu entry. This line may be a physical one painted on the front panel, or there may be no such indicia.

In general, the entries in the various menus which can be displayed in the menu region 130 of the display screen 100 are grouped according to their function. For example, all controls related to specifying trigger criteria are grouped in one (or more) trigger menus, all controls related to setting the vertical parameters of the DSO are grouped in one (or more) vertical menus and so forth. In this set of functional menus, controls which are rarely used by users and those which are often used by users appear together in a single menu because they relate to the same function.

A particular desired menu is displayed, overwriting any prior menu, when a user activates the menu selection switch 300 associated with the desired functional menu. For example, menu selection switch 304 is associated with the menu displaying the trigger controls, the menu selection switch 306 is associated with the signal acquisition menu and the menu selection switch 308 is associated with the vertical menu.

There is also a 'clear menu' menu selection switch 310 which, when activated by the user, will erase any currently displayed menu from the display screen 100. In a preferred embodiment, the menu region 130 is reallocated to display indicators and settings information. When the 'clear menu' switch is activated, information representing current indicators and settings, some which may have been displayed in section 117 of the waveform display region 110, is displayed in the menu region 130 of the display screen 100, so they do not interfere with the waveform display. In an alternate embodiment, the menu region 130 is reallocated to the waveform display region 110. When the 'clear menu' switch is activated, the waveform display region 110 expands to also fill the menu region 130, allowing for more room to display the acquired waveform.

The menu illustrated in Fig. 1 is a basic menu containing basic oscilloscope controls access to which is most often required by a user. The basic menu also is associated with a menu selection switch 302. When the user activates the basic menu selection switch 302 associated with the basic menu, the illustrated menu is displayed on the display screen 100 overwriting any prior menu. The entries in the illustrated basic menu are selected from among those in the complete set of functional menus described above.

A first section 140 of the menu, located on the right hand side of the display screen 100 contains five entries related to the triggering function of the DSO. A first menu entry 141 is associated with bezel button 202, and relates to selecting the trigger type, e.g. edge triggered, or video triggered. When the menu illustrated in Fig. 1 is displayed, each activation of bezel button 202 sequences through the possible choices for the trigger type: edge, video, etc. The second menu entry 142 is associated with bezel button 204 and relates to selection of the trigger mode: automatic or normal. Each activation of bezel switch 204 sequences through the choices: automatic and normal. The third menu entry 143 is associated with bezel button 206 and operates as described above to select the source of the trigger signal: channel 1, channel 2, channel 3, channel 4, external, or line. The fourth menu entry 144 is associated with bezel button 208 and relates to the selection of the type of coupling of the trigger signal: DC, AC, noise rejection, high frequency rejection, low frequency rejection. The fifth menu entry 145 is associated with bezel button 210 and relates to the slope of the triggering signal: positive going, or negative going.

A second section 150 of the menu, located along the bottom of the display screen 100 toward the right hand side contains two entries related to the signal acquisition function of the DSO. A first menu entry 151 is associated with bezel button 212, and includes selections for fast trigger or normal acquisition. A second entry 152 is associated with bezel button 214 and is related to processing performed on the acquired signal: sample, average, envelope displa or peak detection.

A third section 160 of the menu, located along the bottom of the display screen 100 toward the left hand side contains three entries related to the vertical display function of the DSO. A first menu entry 161 is associated with bezel button 216 and is related to the termination for the scope probe: one megohm, or 50 ohms. A second menu entry 162 is associated with bezel button 218 and is related to the coupling of the acquired signal: DC, AC, or ground. A third menu entry 163 is associated with bezel button 220 and relates to activation of the 20MHz signal acquisition circuitry: on or off.

An additional menu entry 131, located at the lower left of the display screen 100 is associated with bezel button 222 and relates to selection of additional such menus. For example, the illustrated basic menu includes menu entries for controls associated with general oscilloscope use. Another basic menu may include menu entries for controls used more often when the oscilloscope is used for observing video signals. Other basic menus may be developed for use when the oscilloscope is being used for other purposes. Activation of the bezel button 222 will cycle through these menus one at a time.

Another menu entry 132, located at the lower right of the display screen 100 is associated with bezel button 224 and relates to activation of the oscilloscope cursor (not shown): on or off. The cursor, when on, is used for various waveform measurements, all in a known manner.

One skilled in the art of oscilloscope user interface design will understand that the details of the entries in the basic menu may change during the interaction of the user with the basic menu. For one example, some entries in the trigger section 140 may change depending upon whether the trigger is selected to be edge or video, or whether the A or B trigger is being adjusted. For another example, the entries in the vertical section 160 may change depending upon which channel is currently being adjusted. One skilled in the art will understand what entries must be changed and what the changed entries must display.

In a preferred embodiment, the menu illustrated in Fig. 1 operates as one of the plurality of menus available to the user. As described above with reference to the functional menus, the basic menu is displayed when the user activates its associated menu selection switch 302, in a known manner. The basic menu is overwritten when the user selects another menu by activating its menu selection switch (302,304,306), or is removed when the user activates the 'clear menu' selection switch 310, also in a known manner. One skilled in the art will realize, however, that it is also possible to arrange for the illustrated basic menu to be displayed when no other menu is displayed, or even to display the basic menu by default when the user activates the 'clear menu' selection switch 310. In either of these cases, no separate basic menu selection switch 302 would be required.

It can be seen that the menu entries on the illustrated basic menu contain the basic oscilloscope controls - those which are generally available on the front panels of analog oscilloscopes, and which are most frequently adjusted by DSO users. It can also be seen that the more advanced controls, related to the more advanced functions, are not given entries in this basic menu. When a user needs to adjust a control which is not displayed on the illustrated basic menu, the functional menu on which that control is displayed is selected by the user, using the menu selection switches 300, in a known manner. The selected functional menu replaces the illustrated basic menu. The desired control may then be adjusted. All of the controls corresponding to menu entries on the illustrated basic menu also appear in at least one of the functional menus. A user can adjust all the oscilloscope controls by proper selection of the functional menu containing that control, but also has access to the basic functions, those used most frequently, from a single basic menu, as illustrated.

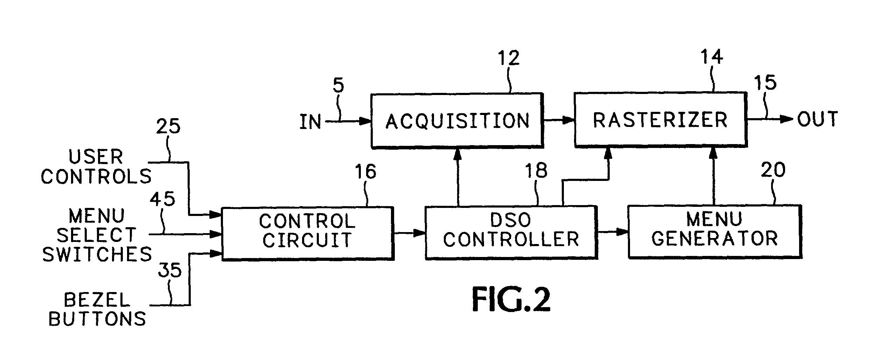

Fig. 2 is a block diagram of a portion of the circuitry of a digital storage oscilloscope according to the present invention. In Fig. 2, only those elements necessary to understand the invention are illustrated. One skilled in the art will understand what other elements are necessary, and will understand how to interconnect those other elements with the illustrated elements.

In Fig. 2, a data signal input terminal 5 (IN) is coupled to a source (not shown) of a signal to be observed. This data signal source may be a node of a circuit whose operation is being analyzed by the user of the DSO, and the input terminal 5 may be an oscilloscope probe. Input terminal 5 is coupled to a data input terminal of an acquisition circuit 12. An output terminal of the acquisition circuit 12 is coupled to a data input terminal of a rasterizer 14. An output terminal of the rasterizer 14 generates a raster signal representing the image to be produced on the display screen 100 (of Fig. 1) and is coupled to an output terminal 15. Output terminal 15 is coupled to utilization circuitry (not shown) which will produce the image represented by the raster signal from the rasterizer 14 on the display screen 100 (of Fig. 2), all in a known manner.

A control circuit 16 receives signals from user controls on the front panel of the DSO through input terminal 25. These user controls can include switches for on/off selections, and dials and knobs for setting variable controls. More specifically, the control circuit 16 receives signals from the bezel buttons 200 (of Fig. 1) through input terminal 35 and from the menu selection switches 300 through input terminal 45. An output terminal of the control circuit 16 is coupled to an input terminal of a DSO controller 18. Respective control output terminals of the DSO controller 18 are coupled to corresponding control input terminals of the acquisition circuit 12, the rasterizer 14 and a menu generator 20. The DSO controller also includes other control output terminals coupled to other circuits in the DSO (not shown). An output terminal of the menu generator 20 is coupled to a second data input terminal of the rasterizer 14.

In operation, the control circuit 16 monitors the user controls, bezel buttons 200, and menu selection switches 300 (of Fig. 1), and determines their respective settings. The control circuit 16, in turn, provides signals representing the state of these controls to the DSO controller 18. The DSO controller produces control signals for the various other circuits in the DSO to control the operation of the DSO in response to the settings of these user controls, all in a known manner. One of the control signals from the DSO controller 18 conditions the menu generator to produce a signal representing the image of a selected menu, such as the basic menu illustrated in Fig. 1. The menu representative signal from the menu generator is supplied to the rasterizer, where it is rasterized and combined with the raster signal representing the waveform of the signal being observed. The output of the rasterizer 14 is a signal representing an image of both the observed waveform in region 110 and the menu in region 130 of the display screen 100.

When a user activates a bezel button 200 (of Fig. 1), the control circuit 16 sends a signal to the DSO controller 18 indicating the activation. The DSO controller 18, knowing what menu it has conditioned the menu generator 20 to display, knows what function that bezel button 200 activation specifies, and sends the appropriate control signal or signals to the appropriate circuit in the DSO, all in a known manner. This may include the DSO controller 18 sending a signal to the menu generator 20 to change the details of the menu entries in the currently displayed menu, in a manner described above.

In a preferred embodiment, when a user activates a menu selection switch 300, the control circuit 16 sends a signal to the DSO controller 18 indicating the activation. The DSO controller 18, in turn, sends a signal to the menu generator 20 conditioning it to display the menu associated with the menu selection switch 300 which was activated. If the 'clear menu' selection switch 310 was activated, the DSO controller 18 sends a signal to the menu generator 20 to display no menu, and also sends a control signal to the rasterizer 14 to expand the waveform display region 110 over the menu display region 130.

As described above, in an alternative embodiment, when no other menu is displayed, or when the user presses the "menu clear" menu selection switch, the DSO controller 18 sends a signal to the menu generator 20 which conditions the menu generator 20 to display the basic menu illustrated in Fig. 1, and process bezel button 200 activations in the appropriate manner for that menu.

## Claims

1. A method for controlling a digital storage oscilloscope having a plurality of controls and comprising a display screen, the method comprising the steps of:
specifying, from among the plurality of controls, a plurality of basic controls which are more frequently used by a user of the oscilloscope; and
displaying a basic menu on the display screen containing a plurality of entries respectively corresponding to the basic controls.

2. The method of claim 1, wherein the digital storage oscilloscope further has a group of functions to one of which each of the plurality of controls is related, and wherein:
the displaying step comprises the step of selectively displaying either the basic menu or one of a group of functional menus on the display screen, in response to a user input, the group of functional menus respectively corresponding to the group of functions, and each menu in the group of functional menus containing a plurality of entries respectively corresponding to the plurality of controls related to the function corresponding to the displayed menu.

3. The method of claim 2 wherein the displaying step further comprises the step of displaying one of the group of functional menus in response to activation of a menu selection switch corresponding to the displayed functional menu.

4. The method of claim 2 wherein the displaying step further comprises the step of displaying the basic menu in response to activation of a basic menu selection switch.

5. The method of claim 2 wherein the displaying step further comprises the step of displaying the basic menu when none of the group of functional menus is being displayed in the display screen.

6. The method of claim 2 wherein the displaying step further comprises the step of displaying the basic menu in response to a user 'clear menu' signal.

7. The method of claim 2 wherein the displaying step further comprises the step of displaying no menu in response to a user 'clear menu' signal.

8. The method of claim 1 wherein the plurality of basic controls is related to a group of functions including a trigger control function, a vertical control function and a signal acquisition control function, and wherein:
the displaying step comprises the step of displaying the basic menu having a trigger section containing entries related to the trigger control function, a vertical section containing entries related to the vertical control function and an acquisition section containing entries related to the signal acquisition control function.

9. The method of claim 8 wherein:
the trigger control function includes a trigger type control, a trigger mode control, a trigger source control, a trigger coupling control and a trigger slope control;
the vertical control function includes a termination control, a vertical coupling control, and a high frequency control; and
the signal acquisition control function includes a signal acquisition control, and a signal processing control; wherein:
the displaying step further comprises the steps of:
displaying in a trigger section a menu entry corresponding to the trigger type control, a menu entry corresponding to the trigger mode control, a menu entry corresponding to the trigger source control, a menu entry corresponding to the trigger coupling control, and a menu entry corresponding to the trigger slope control;
displaying in a vertical section a menu entry corresponding to the termination control, a menu entry corresponding to the vertical coupling control, and a menu entry corresponding to the high frequency control; and
displaying in a acquisition section a menu entry corresponding to the signal acquisition control, and a menu entry corresponding to the signal processing control.

10. The method of claim 9 wherein the displaying step further comprises the step of displaying a menu entry related to activation of a cursor used in performing measurements of a displayed waveform.

11. The method of claim 9 wherein:
the specifying step further comprises the step of specifying, from among the plurality of controls, a second plurality of basic controls which are more frequently used by a user of the oscilloscope for a purpose different than that of the first mentioned plurality of basic controls; and
the displaying step further comprises the step of displaying one of a first basic menu having menu entries respectively corresponding to the first mentioned plurality of basic controls and a second basic menu having menu entries respectively corresponding to the second plurality of basic controls, wherein each one of the first and second basic menus has a menu entry for displaying the other of the first and second basic menus.

12. A digital storage oscilloscope having a plurality of controls, comprising:
a display screen; and
menu generation circuitry, coupled to the display screen, for displaying a basic menu on the display screen having a plurality of entries respectively corresponding to a plurality of basic controls, selected from the plurality of controls, which are more frequently used by a user of the oscilloscope.

13. The oscilloscope of claim 12 wherein:
the digital storage oscilloscope further has a group of functions to one of which each of the plurality of controls is related; and
the menu generation circuitry further comprises circuitry for selectively displaying either the basic menu or one of a group of functional menus on the display screen, in response to a user control signal, the group of functional menus respectively corresponding to the group of functions, each menu in the group of functional menus containing a plurality of entries respectively corresponding to the plurality of controls related to the function corresponding to the menu.

14. The oscilloscope of claim 13 further comprising:
a set of menu selection switches respectively corresponding to the basic menu and each of the group of functional menus; wherein:
the menu generation circuitry further comprises circuitry for displaying one of the group of functional menus in response to activation of the menu selection switch corresponding to the displayed functional menu.

15. The oscilloscope of claim 14, wherein the menu generation circuitry further comprises circuitry to display the basic menu in response to activation of the basic menu selection switch.

16. The oscilloscope of claim 14, further comprising:
a 'clear menu' selection switch; wherein
the menu generation circuitry further comprises circuitry to display the basic menu in response to activation of the 'clear menu' selection switch.

17. The oscilloscope of claim 14, further comprising:
a 'clear menu' selection switch; wherein
the menu generation circuitry further comprises circuitry to display no menu in response to activation of the 'clear menu' selection switch.

18. The oscilloscope of claim 13 wherein the menu generation circuitry further comprises circuitry to display the basic menu when none of the group of functional menus are being displayed.

19. The oscilloscope of claim 12 wherein the plurality of basic controls are each related to one of a group of functions which include trigger control function, vertical control function and signal acquisition control function, and wherein:
the menu generation circuitry comprises circuitry for displaying a menu having a trigger section containing entries related to the trigger control function, a vertical section containing entries related to the vertical control function and an acquisition section containing entries related to the signal acquisition control function.

20. The oscilloscope of claim 19 wherein:
the trigger control function includes a trigger type control, a trigger mode control, a trigger source control, a trigger coupling control and a trigger slope control;
the vertical control function includes a termination control, a vertical coupling control, and a high frequency control; and
the signal acquisition control function includes a signal acquisition control, and a signal processing control; and wherein:
the menu generation circuitry comprises:
circuitry for displaying in the trigger section a menu entry corresponding to the trigger type control, a menu entry corresponding to the trigger mode control, a menu entry corresponding to the trigger source control, a menu entry corresponding to the trigger coupling control, and a menu entry corresponding to the trigger slope control;
circuitry for displaying in the vertical section a menu entry corresponding to the vertical termination control, a menu entry corresponding to the vertical coupling control, and a menu entry corresponding to the high frequency control; and
circuitry for displaying in the acquisition section a menu entry corresponding to the trigger acquisition control, and a menu entry corresponding to the signal processing control.

21. The oscilloscope of claim 20 wherein the menu generation circuitry further comprises circuitry for displaying a menu entry relating to activation of a cursor used in performing measurements of a displayed waveform.

22. The oscilloscope of claim 20 wherein:
the menu generating circuitry further comprises circuitry for displaying the first mentioned basic menu having menu entries respectively corresponding to the first mentioned plurality of basic controls, and a second basic menu having menu entries respectively corresponding to a second plurality of basic controls which are more frequently used by a user of the oscilloscope for a purpose different than that of the first mentioned plurality of basic controls, wherein each one of the first and second basic menus includes a menu entry related to displaying the other of the first and second basic menus.

23. A computer program for performing a method as claimed in any one of claims 1 to 11.
